Europäisches Patentamt

European Patent Office

Office européen des brevets

(19)

(11) Veröffentlichungsnummer: **0 320 525 B1**

(12)

# EUROPÄISCHE PATENTSCHRIFT

(45) Veröffentlichungstag der Patentschrift: **16.10.91**

(51) Int. Cl.⁵: **H03M 1/36, H03K 5/24**

(21) Anmeldenummer: **87118603.7**

(22) Anmeldetag: **15.12.87**

(54) **Abtast-Halte-Stufe und deren Anwendung in Parallel-A/D-Wandlern.**

(43) Veröffentlichungstag der Anmeldung:
**21.06.89 Patentblatt 89/25**

(45) Bekanntmachung des Hinweises auf die
Patenterteilung:
**16.10.91 Patentblatt 91/42**

(84) Benannte Vertragsstaaten:
**DE FR GB IT NL**

(56) Entgegenhaltungen:
**EP-A- 0 161 973**
**FR-A- 2 341 231**
**US-A- 4 147 943**

**ELECTRONIC DESIGN, Band 29, Nr. 2, Januar 1982, Seiten 75-79; Waseca, MN, US; W.K. BUCKLEN: "Video digitizing gets extra bit of resolution from flash ADC"**

(73) Patentinhaber: **Deutsche ITT Industries GmbH**
**Hans-Bunte-Strasse 19 Postfach 840**
**W-7800 Freiburg i.Br.(DE)**

(72) Erfinder: **Höhn, Wolfgang, Dipl.-Ing.**
**Am Bühl 14**
**W-7815 Kirchzarten(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Bei Parallel-A/D-Wandlern ( = Parallel-Analog/Digital-Wandlern) steigt bekanntlich die Anzahl der eingangsseitig erforderlichen Komparatoren und Latchstufen exponentiell mit dem geforderten Auflösungsvermögen und damit der Stellenzahl der am Ausgang gewünschten Digitalsignale, für die häufig der natürliche Dualcode benutzt wird, so daß ein in diesem Sinn siebenstelliger Parallel-A/D-Wandler z.B. $2^7$ = 128 Komparatoren und ebensoviele Latchstufen enthält. Für jede weitere Stelle verdoppelt sich jeweils die Anzahl der Komparatoren und der Latchstufen, und die zur monolithischen Integrierung des Parallel-A/D-Wandlers erforderliche Kristallfläche vergrößert sich in etwa um den gleichen Betrag. Komparator - und Latch-Funktion Können in einer Abtast-Halte-Stufe, wie sie beispielsweise in EP-A-O 161 973 beschrieben ist, zusammengefaßt werden.

Da es sich bei den mehrstelligen Parallel-A/D-Wandlern um aufwendige elektronische Bauelemente handelt, ist man bestrebt, diese mehrfach zur Analog-Digital-Wandlung auszunutzen und sie beispielsweise durch einen vorgeschalteten Multiplexer zur Wandlung von mindestens zwei voneinander unabhängigen Analogsignalen auszunutzen. Es hat sich jedoch gezeigt, daß dies mit folgenden Schwierigkeiten verbunden ist. Der dem A/D-Wandler vorgeschaltete Multiplexer bewirkt, daß der Analogeingang des A/D-Wandlers im Extremfall vom positiven Maximalwert des einen Analogsignals auf den Minimalwert des anderen Analogsignals umgeschaltet wird, was bedeutet, daß die Eingangskapazität des Analogeingangs, die bei einem siebenstelligen A/D-Wandler z.B. in der Größenordnung von einigen 10 pF liegt, umgeladen werden muß. Dies führt wegen der von der Eingangskapazität zusammen mit dem Eingangswiderstand des A/D-Wandlers und dem Ausgangswiderstand des Multiplexers gebildeten Zeitkonstante zu umso größeren Signalverfälschungen bei der Wandlung, je höher die in den Analogsignalen enthaltenen Frequenzanteile sind. Insbesondere bei Analogsignalen, wie sie in Videorecordern und Fernsehempfängern auftreten, hat sich gezeigt, daß die Vorschaltung eines Multiplexers vor den A/D-Wandler praktisch unmöglich ist.

Der in den Ansprüchen gekennzeichneten Erfindung liegt somit die Aufgabe zugrunde, eine Abtast-Halte-Stufe und deren Anwendung in Parallel-A/D-Wandlern anzugeben, mit dem mindestens zwei voneinander unabhängige Analogsignale nach dem Multiplexprinzip verarbeitet werden können.

Die Lösung dieser Aufgabe geht von dem Grundgedanken aus, den Multiplexer in den Eingangsteil des Analog-Digital-Wandlers einzubeziehen, und zwar derart, daß die erwähnte Umladung der Eingangskapazität vermieden ist.

Ein Vorteil der erfindungsgemäßen Abtast-Halte- Stufe ist darin zu sehen, daß zusätzlich zu den üblicherweise im Komparator und Latchstufe vorhandenen Transistoren pro weiteres zu verarbeitendes Analogsignal lediglich drei weitere Transistoren und an den beiden Entkopplungstransistoren jeweils ein weiterer gesteuerter Strompfad vorzusehen sind. Somit ist der zusätzliche Kristallflächenaufwand im Hinblick auf die Gesamtfläche des A/D-Wandlers praktisch vernachlässigbar.

Die Erfindung wird nun anhand der Figuren der Zeichnung näher erläutert.

Fig. 1 zeigt als Ausführungsbeispiel das Schaltbild der ersten und der letzten Abtast-Halte-Stufe eines mit Bipolartransistoren realisierten Parallel-A/D-Wandlers nach der Erfindung, und

Fig. 2 zeigt die Kurvenform von beim Ausführungsbeispiel nach Fig. 1 vorzugsweise zu verwendenden Taktsignalen.

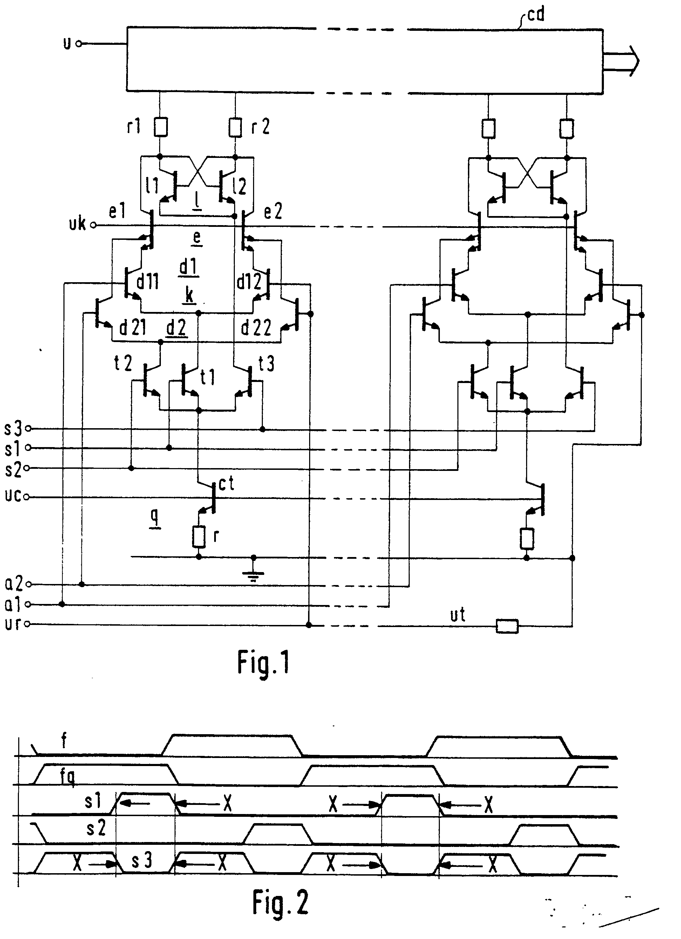

Beim in Fig. 1 gezeigten Schaltbild eines mit Bipolartransistoren realisierten Ausführungsbeispiels sind die erste und die letzte Stufe eines Parallel-A/D-Wandlers gezeigt, wobei die jeweilige Abtast-Halte-Stufe mit ihren einzelnen Transistoren und passiven Bauelementen gezeigt ist, während der zugehörige Codierer lediglich schematisch angedeutet ist, da entsprechende Schaltungen dem Fachmann geläufig sind.

Die zur ersten Parallel-A/D-Wandlerstufe gehörende Abtast-Halte-Stufe ist mit Bezugszeichen versehen. Sie setzt sich aus den Teilschaltungen Konstantstromquelle q, Komparator k, Entkoppelstufe e und Latchstufe l zusammen.

Der Komparator k enthält die erste differenzverstärkerartige Schaltung d1 aus den beiden ersten Differenztransistoren d11, d12, deren gesteuerte Strompfade einerseits gemeinsam über den gesteuerten Strompfad des ersten Takttransistors t1 und die Konstantstromquelle q am Schaltungsnullpunkt und andererseits jeweils über den gesteuerten Strompfad eines der beiden Entkoppeltransistoren e1, e2 und jeweils über das Lastelement r1, r2 mit der Betriebsspannungsquelle u, die den Codierer cd versorgt, gekoppelt sind.

Bei den gesteuerten Strompfaden des mit Bipolartransistoren realisierten Ausführungsbeispiels der Fig. 1 handelt es sich um die Kollektor-Emitter-Strecke entsprechender Transistoren, die in Fig. 1 alle vom gleichen Leitungstyp, nämlich vom npn-Typ sind. Ausgehend vom Lastelement r1 liegen also in der folgenden Reihenfolge die Kollektor-Emitter-Strecken der Transistoren e1, d11, t1, ct - das ist der Transistor der Konstantstromquelle q - sowie der dazu gehörende Widerstand r in Serie. Gleiches gilt für die mit dem zweiten Lastelement r2 in Serie liegenden Transistoren e2, d12, t1, ct und wiederum den Widerstand r. Es ist somit ersichtlich, daß die Differenztransistoren d11, d12 emitterseitig miteinander verbunden sind.

Der Komparator k enthält ferner die zweite differenzverstärkerartige Schaltung d2 aus den beiden zweiten Differenztransistoren d21, d22, deren gesteuerte Strompfade einerseits gemeinsam über den gesteuerten Strompfad des zweiten Takttransistors t2 und die Konstantstromquelle q am Schaltungsnullpunkt und andererseits jeweils über den weiteren gesteuerten Strompfad eines der beiden Entkoppeltransistoren e1, e2 und das jeweilige Lastelement r1, r2 mit der Betriebsspannungsquelle u gekoppelt sind. Die Entkoppeltransistoren e1, e2 weisen somit jeweils einen zweiten Emitter auf, der mit dem Kollektor der Differenztransistoren d21 bzw. d22 verbunden ist, und sind mit ihrer Basis auf die konstante Spannung uk gelegt. Die beiden zweiten Differenztransistoren d21, d22 sind somit an ihren Emittern miteinander verbunden.

Die Latchstufe l enthält die beiden Latchtransistoren l1, l2, deren gesteuerte Strompfade einerseits gemeinsam über den dritten Takttransistor t3 und die Konstantstromquelle q am Schaltungsnullpunkt liegen und andererseits jeweils über eines der beiden Lastelemente r1, r2 mit der Betriebsspannungsquelle u gekoppelt sind. Ferner ist der Steueranschluß des einen Latchtransistors l1 am Verbindungspunkt des anderen Latchtransistors l2 mit dessen Lastelement r2 angeschlossen und umgekehrt; es ergibt sich somit die für Latchstufen übliche gegenseitige Kreuzkopplung. Alle drei Takttransistoren t1, t2, t3 sind an ihren Emittern miteinander verbunden und führen zur Konstantstromquelle q.

Im mit Bipolartransistoren realisierten Ausführungsbeispiel nach Fig. 1 sind die gesteuerten Strompfade der einzelnen Transistoren deren jeweilige Kollektor-Emitter-Strecke; bei Realisierung der Erfindung mittels Isolierschicht-Feldeffekttransistoren, also in der sogenannten MOS-Technik ist der gesteuerte Strompfad dann selbstverständlich die Source-Drain-Strecke von entsprechenden Transistoren. Die Steuereingänge sind bei Bipolartransistoren deren Basis, dagegen bei MOS-Transistoren deren Gate. In der MOS-Technik ist der weitere gesteuerte Strompfad der Entkoppeltransistoren durch einen weiteren Entkoppeltransistor zu realisieren.

Die Lastelemente können durch passive oder aktive Schaltungselemente realisiert sein, wie z.B. diffundierte Widerstände, bipolare Konstantstromtransistoren oder als Widerstand betriebene MOS-Transistoren.

Durch bezüglich des Analogsignaleingangs parallele Anordnung von mehreren Abtast-Halte-Stufen läßt sich wie üblich ein Parallel-A/D-Wandler aufbauen. Dies ist in Fig. 1 dadurch angedeutet, daß die erste und die letzte Stufe eines derartigen Wandlers gezeigt sind. Dabei sind die Steuereingänge aller einen ersten Differenztransistoren d11 miteinander verbunden und mit dem ersten Analogsignal a1 gespeist. Die Steuereingänge aller einen zweiten Differenztransistoren d21 sind ebenfalls miteinander verbunden und mit dem zweiten Analogsignal a2 gespeist.

Die Steuereingänge der anderen ersten und anderen zweiten Differenztransistoren d12, d22 sind miteinander verbunden und bilden einen Eingang für eine Referenzspannung. Zur Erzeugung des für jede Stufe eigenen Referenzspannungswerts, die sich untereinander im allgemeinen um einen konstanten Betrag unterscheiden, ist der ohmsche Spannungsteiler ut vorgesehen, der zwischen der Referenzspannungsquelle ur und einem anderen konstanten Potential, vorzugsweise dem Schaltungsnullpunkt wie in Fig. 1, liegt. Dieser Spannungsteiler hat soviel Abgriffe, wie Komparatoren vorgesehen sind, wobei, wie es für das Ausführungsbeispiel der Fig. 1 zutrifft, der Anschluß der Referenzspannung ur und der Schaltungsnullpunkt mit zu den Abgriffen gerechnet ist. Von den in diesem Falle n-2 Widerständen - wenn n die Anzahl der Abtast-Halte-Stufen des Parallel-A/D-Wandlers ist - ist in Fig. 1 der zur vorletzten Stufe gehörende Widerstand gezeigt.

Den Steuereingängen aller Takttransistoren t1 ist das erste Taktsignal s1 und aller zweiten Takttransistoren d2 das zweite Taktsignal s2 zugeführt. Die Steuereingänge aller dritten Takttransistoren t3 sind mit dem dritten Taktsignal s3 gespeist, oder es kann ihnen auch eine konstante Spannung zugeführt sein.

Die drei Taktsignale s1, s2, s3 sind untereinander nichtüberlappend, und das dritte Taktsignal s3 hat die doppelte Frequenz des zweiten, das mit dem ersten gleichfrequent ist.

Somit läßt sich mit den Abtast-Halte-Stufen der Erfindung ein multiplexendes A/D-Wandeln der beiden Analogsignale a1, a2 ohne Vorschaltung eines eigenen Multiplexers vor den A/D-Wandler realisieren, da das Multiplexen in die Abtast-Halte-Stufen mit einbezogen ist. Dadurch entfällt auch das eingangs erwähnte, insbesondere bei hochfrequenten Signalen störende, Umladen der Eingangskapazität des A/D-Wandlers, da für jedes Analogsignal ein eigener A/D-Wandlereingang vorgesehen ist, der dauernd mit dem entsprechenden Analogsignal gespeist ist. Die erfindungsgemäße Einbeziehung des Multiplexens in die Abtast-Halte-Stufen erfordert pro Stufe lediglich drei weitere Transistoren sowie jeweils einen weiteren gesteuerten Strompfad der Entkoppeltransistoren.

Im Bedarfsfall können nach dem der Erfindung zugrundeliegenden Prinzip auch mehr als zwei Analogsignale multiplexend A/D-gewandelt werden, indem pro weiteres Analogsignal eine weitere differenzverstärkerartige Schaltung mit zugehörigem Takttransistor und weiterem gesteuerten Strompfad der Entkoppeltransistoren vorgesehen wird.

Die Fig. 2 zeigt verschiedene Kurvenformen für eine Realisierung der Erfindung mittels Bipolartransistoren, die nach der bekannten ECL-Technik ( = Emitter Coupled Logic) im Halbleiterkristall einer integrierten Schaltung gebildet sind. Die beiden oberen Kurven der Fig. 2 zeigen die zum Betrieb von ECL-Schaltungen üblicherweise erforderlichen beiden nichtüberlappenden Taktsignale f, fq, deren letzteres fq durch Invertierung des ersteren f entstanden ist. Daraus resultiert die geringfügige Flankenverzögerung des Taktsignals fq gegenüber dem Taktsignal f. Mittels einer dem Fachmann ohne weiteres geläufigen entsprechenden logischen Verknüpfungsschaltung werden aus den beiden Taktsignalen f, fq die drei Taktsignale s1, s2, s3 gebildet, wobei auf die exakte Flankenkoinzidenz zu achten ist.

Ferner ist es vorteilhaft, wenn das Puls-Pausen-Verhältnis des dritten Taktsignals s3 gleich 1:1 ist und wenn die Impulse des ersten Taktsignals s1 mit den ungeradzahligen Impulspausen des dritten Taktsignals s3 und die Impulse des zweiten Taktsignals s2 mit den geradzahligen Impulspausen des dritten Taktsignals s3 zusammenfallen, wie dies die unteren drei Kurven der Fig. 2 zeigen. Durch diese gegenseitige zeitliche Relation der drei Taktsignale s1, s2, s3, wobei insbesondere auf die Flankenkoinzidenz zwischen dem ersten und dem dritten bzw. dem zweiten und dem dritten Taktsignal zu achten ist, vgl. die mit X markierten Flanken in Fig. 2, ist gewährleistet, daß die Übernahme des jeweiligen Abtastwerts in die Latchstufe bei der jeweiligen Rückflanke des dritten Taktsignals s3 erfolgt und daß andererseits in den beiden Differenzstufen d1, d2 ausreichend Zeit zur Verfügung steht, den entsprechenden Abtastwert des jeweiligen Analogsignals zu bilden.

Ein mit den erfindungsgemäßen Abtast-Halte-Stufen aufgebauter Parallel-A/D-Wandler wird bevorzugt im Signalweg eines Fernsehempfänger-Videorecorder-Kits zur gemultiplexten A/D-Wandlung des Luminanz- und des Chrominanzsignals nach dem Super-VHS-Standard verwendet. Nach diesem Standard werden das Luminanzsignal und das Chrominanzsignal in entsprechender Frequenzlage als zwei voneinander getrennte Signale auf das Videoband übertragen und von dort wieder abgenommen. Sollen diese Signale digital weiterverarbeitet werden, wie dies in den üblichen digitalen Fernsehempfängern geschieht, so sind die erwähnten beiden Signale, die Analogsignale sind, A/D-zuwandeln, was mit der Erfindung ohne einen dem A/D-Wandler vorzuschaltenden Multiplexer erreicht werden kann.

## Patentansprüche

1. Abtast-Halte-Stufe mit einem getakteten Komparator (k) und mit einer diesem über eine Entkoppelstufe (e) ausgangsseitig parallelgeschalteten Latchstufe (l),

- wobei der Komparator (k) enthält:
  - eine erste differenzverstärkerartige Schaltung (d1) aus zwei ersten Differenztransistoren (d11, d12), deren gesteuerte Strompfade einerseits gemeinsam über den gesteuerten Strompfad eines ersten Takttransistors (t1) und eine Konstantstromquelle (q) am Schaltungsnullpunkt und andererseits jeweils über den gesteuerten Strompfad je eines von zwei Entkoppeltransistoren (e1, e2) und jeweils ein Lastelement (r1, r2) mit der Betriebsspannungsquelle (u) gekoppelt sind, und
  - eine zweite differenzverstärkerartige Schaltung (d2) aus zwei zweiten Differenztransistoren (d21, d22), deren gesteuerte Strompfade einerseits gemeinsam über den gesteuerten Strompfad eines zweiten Takttransistors (t2) und die Konstantstromquelle (q) am Schaltungsnullpunkt und andererseits jeweils über einen weiteren gesteuerten Strompfad je eines der beiden Entkoppeltransistoren (e1, e2) und das jeweilige Lastelement (r1, r2) mit der Betriebsspannungsquelle (u) gekoppelt sind, und
- wobei die Latchstufe (l) zwei Latchtransistoren (l1, l2) enthält,
  - deren gesteuerte Strompfade einerseits gemeinsam über einen dritten Takttransistor (t3) und die Konstantstromquelle (q) am Schaltungsnullpunkt liegen und andererseits jeweils über je eines der beiden Lastelemente (r1, r2) mit der Betriebsspannungsquelle (u) gekoppelt sind und
  - bei denen der Steueranschluß des einen Latchtransistors (l1) am Verbindungspunkt des anderen Latchtransistors (l2) mit dessen Lastelement (r2) liegt und umgekehrt.

2. Parallel-A/D-Wandler mit mehreren Abtast-Halte-Schaltungen nach Anspruch 1, bei denen

- die Steuereingänge aller einen ersten Differenztransistoren (d11) miteinander verbunden und mit einem ersten Analogsignal (a1) und die Steuereingänge aller einen zweiten Differenztransistoren (d21) miteinander verbunden und mit einem zweiten Analogsignal (a2) gespeist sind,
- in jedem Komparator (k) die Steuereingänge des anderen ersten und des anderen zweiten Differnztransistors (d12, d22) gemeinsam einen Referenzspannungseingang bilden,
- ein ohmscher Spannungsteiler (ut) mit soviel Abgriffen, wie Komparatoren vorgesehen sind, zwischen einer Referenzspannungsquelle (ur) und einem anderen konstanten Potential liegt, von denen jeweils ein Abgriff mit dem Referenzspannungseingang eines der Komparatoren (k) verbunden ist,
- den Steuereingängen aller ersten Takttransistoren (t1) ein erstes Taktsignal (s1) und den Steuereiningängen aller zweiten Takttransistoren (t2) ein zweites Taktsignal (s2) sowie den Steuereingängen aller dritten Takttransistoren (t3) ein drittes Taktsignal (s3) oder eine Konstantspannung zugeführt ist und
- die drei Taktsignale (s1, s2, s3) untereinander nichtüberlappend sind sowie das dritte Taktsignal (s3) die doppelte Frequenz des zweiten (s2) hat, das mit dem ersten (s1) gleichfrequent ist.

3. Parallel-A/D-Wandler nach Anspruch 2, bei dem das Puls/Pausen-Verhältnis des dritten Taktsignals (s3) gleich 1:1 ist und die Impulse des ersten Taktsignals (s1) mit den ungeradzahligen Impulspausen des dritten Taktsignals (s3) und die Impulse des zweiten (s2) mit den geradzahligen Impulspausen des dritten (s3) zusammenfallen.

4. Verwendung eines Parallel-A/D-Wandlers nach Anspruch 2 oder 3 im Signalweg eines Fernsehempfänger-Videorecorder-Kits zur gemultiplexten A/D-Wandlung des Luminanz- und des Chrominanzsignals nach dem Super-VHS-Standard.

**Claims**

1. Sample-and-hold stage comprising a clocked comparator (k) and a latch stage (l) having its output connected in parallel with the comparator (k) via a decoupling stage (e),

- the comparator (k) containing:

  - a first differential-amplifier-like circuit (d1) consisting of two first differential transistors (d11, d12) whose controlled current paths are connected together at one end forming a junction point which is grounded through the controlled current path of a first clock transistor (t1) and a constant-current source (q), while at the other end each of the controlled current paths is coupled to the supply-voltage source (u) via the controlled current path of one of two decoupling transistors (e1, e2) and one of two load elements (r1, r2), and

  - a second differential-amplifier-like circuit (d2) consisting of two second differential transistors (d21, d22) whose controlled current paths are connected together at one end forming a junction point which is grounded through the controlled current path of a second clock transistor (t2) and the constant-current source (q), while at the other end each of the two controlled current paths is coupled to the supply-voltage source (u) via an additional controlled current path of one of the two decoupling transistors (e1, e2) and the respective load element (r1, r2), and

- the latch stage (l) containing two latch transistors (l1, l2)

  - whose controlled current paths are connected together at one end forming a junction point which is grounded through a third clock transistor (t3) and the constant-current source (q), while at the other end each of the two controlled current paths is coupled to the supply-voltage source (u) via one of the two load elements (r1, r2), and

  - the control terminal of one of which (l1) is connected to the junction point of the other latch transistor (l2) with the load element (r2) of the latter, and vice versa.

2. parallel A/D converter comprising a plurality of sample-and-hold stages as claimed in claim 1, wherein

- the control inputs of all first differential transistors (d11) on one side are connected together and fed with a first analog signal (a1), and the control inputs of all second differential transistors (d21) on said one side are connected together and fed with a second analog signal (a2),
- in each comparator (k), the control inputs of the first and second differential transistors (d12, d22) on the other side are connected together to form a reference-voltage input,

- a resistive voltage divider (ut) having as many taps as there are comparators is connected between a reference-voltage source (ur) and another constant potential, with each of the taps connected to the reference-voltage input of one of the comparators (k),
- a first clock signal (s1) is applied to the control inputs of all first clock transistors (t1), a second clock signal (s2) to the control inputs of all second clock transistors (t2), and a third clock signal (s3) or a constant voltage to the control inputs of all third clock transistors (t3), and
- the three clock signals (s1, s2, s3) do not overlap one another, and the third clock signal (s3) has twice the frequency of the second (s2), which is equal in frequency to the first (s1).

3. A parallel A/D converter as claimed in claim 2, wherein the mark/space ratio of the third clock signal (s3) is 1:1, and wherein the pulses of the first clock signal (s1) coincide with the odd-numbered spaces between the pulses of the third clock signal (s3), while the pulses of the second clock signal (s2) coincide with the even-numbered spaces between the pulses of the third clock signal (s3).

4. Use of a parallel A/D converter as claimed in claim 2 or 3 in the signal path of a television-receiver-video-recorder combination for multiplexed A/D conversion of the luminance and chrominance signals in accordance with the super-VHS standard.

## Revendications

1. Étage échantillonneur-bloqueur comportant un comparateur (k) commandé de façon cadencée et un étage de verrouillage (l) branché, côté sortie, en parallèle avec ce comparateur, par l'intermédiaire d'un étage de découplage (e), et dans lequel
   - le comparateur (k) contient :
     - un premier circuit (d1) du type à amplificateurs différentiels, constitué de deux premiers transistors différentiels (d11,d12), dont les voies de courant commandées sont raccordées d'une part ensemble par l'intermédiaire de la voie de courant commandée d'un premier transistor de cadence (t1) et d'une source de courant constant (q), au neutre du circuit et d'autre part, respectivement par l'intermédiaire de la voie de courant commandée, de l'un respectif de deux transistors de découplage (e1,e2) et respectivement d'un élément de charge (r1,r2), à la source de tension de service (u), et
     - un second circuit (d2) du type à amplificateurs différentiels constitué par deux transistors différentiels (d21,d22), dont les voies de courant commandés sont raccordées d'une part ensemble par l'intermédiaire de la voie de courant commandée d'un second transistor de cadence (t2) et d'une source de courant constant (q), au neutre du circuit et d'autre part, respectivement par l'intermédiaire de la voie de courant commandée, de l'un respectif de deux transistors de decouplage (e1,e2) et respectivement d'un élément de charge (r1,r2), à la source de tension de service (u), et
   - l'étage de verrouillage (1) contient deux transistors de verrouillage (11,12),
     - dont les voies de courant commandées sont raccordées d'une part ensemble par l'intermédiaire d'un troisième transistor de cadence (t3) et de la source de courant constant (q) au neutre du circuit et d'autre part, respectivement par l'intermédiaire de l'un respectif des deux éléments de charge (r1,r2) à la source de tension de service (u), et
     - dans lesquels la borne de commande d'un transistor de verrouillage (11) est raccordée au point de jonction de l'autre transistor de verrouillage (e2) et de son élément de charge (r2), et inversement.

2. Convertisseur analogique/numérique parallèle comportant plusieurs circuits échantillonneurs-bloqueurs selon la revendication 1, dans lequel
   - les entrées de commande de tous les premiers transistors différentiels (d11) sont reliées entre elles et reçoivent un premier signal analogique (a1), et les entrées de commande de tous les seconds transistors différentiels (d21) sont reliées entre elles et sont alimentées par un second signal analogique (a2),
   - dans chaque comparateur (k), les entrées de commande de l'autre premier et de l'autre second transistor différentiel (d12,d22) forment en commun une entrée pour la tension de référence,
- un diviseur ohmique de tension (ut), qui comporte autant de prises qu'il est prévu de comparateurs, est branché entre une source de la tension de référence (ur) et un autre potentiel constant, respectivement une prise étant raccordée à l'entrée de la tension de référence de l'un des comparateurs (k),
- un premier signal de cadence (s1) est envoyé aux entrées de commande de tous les premiers transistors de cadence (t1) et un second signal de cadence (s2) est envoyé aux entrées de commande de tous les seconds transistors de cadence (t2) et un troisième signal de cadence (s3) ou une tension constante est envoyé aux entrées de commande de tous les troisièmes transistors de cadence (t3), et
- les trois signaux de cadence (s1,s2,s3) ne sont pas réciproquement en chevauchement, et le troisième signal de cadence (s3) possède une fréquence égale au double de celle du second signal (s2), qui possède la même fréquence que le premier signal (s1).

3. Convertisseur analogique/numérique parallèle suivant la revendication 2, dans lequel le rapport impulsion/pause du troisième signal de cadence (s3) est égal à 1:1 et les impulsions du premier signal de cadence (s1) coïncident avec les pauses impaires entre impulsions du troisième signal de cadence (s3), et les impulsions du second signal de cadence (s2) coïncident avec les pauses paires entre les impulsions du troisième signal de cadence (s3).

4. Utilisation d'un convertisseur analogique/ numérique parallèle suivant la revendication 2 ou 3 dans la voie de transmission de signaux d'un ensemble récepteur de télévision-récepteur vidéo pour réaliser la conversion analogique/numérique mutiplexée du signal de luminance et du signal de chrominance selon la norme super-VHS.

Fig.1

Fig.2